# FASCICULE DE BREVET EUROPEEN

(11) **EP 2 209 137 B1**
(45) Date de publication et mention de la délivrance du brevet: **12.10.2011**
(21) Numéro de dépôt: 10354001.9
(22) Date de dépôt: 05.01.2010
(51) Int. Cl.: H01L 21/66

(54) **Procédé de révélation de dislocations émergentes dans un élément cristallin à base de germanium**
Verfahren zur Aufdeckung auftretender Kristallversetzungen in einem kristallinen Element auf Germaniumbasis
Method for revealing emerging dislocations in a crystalline germanium based material

(30) Priorité: 16.01.2009 FR 0900198
(43) Date de publication de la demande: 21.07.2010
(73) Titulaire: Commissariat à l'Énergie Atomique et aux Énergies Alternatives, 75015 Paris (FR)
(72) Inventeur: Sanchez, Loic, 38500 Voiron (FR); Deguet, Chrystel, 38330 Saint Ismier (FR)
(74) Mandataire: Dubreu, Sandrine

(56) Documents cités:
- EP-A- 1 758 158
- WO-A-2005/086222
- US-B1- 6 403 385
- Solid State Phenomena Scitec Publications Ltd. Switzerland, vol. 134, no. xp008109913, 1 janvier 2008 (2008-01-01), pages 83-86, XP002541628 ISSN: 1012-0394

## Description

### Domaine technique de l'invention

L'invention concerne un procédé de révélation de dislocations émergentes d'un élément ayant au moins une couche superficielle à base de germanium cristallin.

### État de la technique

Les propriétés électriques d'un matériau sont influencées par la présence de défauts dans le réseau cristallin du matériau semi-conducteur. Plus particulièrement, les dislocations émergentes qui traversent les couches supérieures du matériau donnent des indications sur la qualité des propriétés semi-conductrices du matériau. Plusieurs techniques de révélation et d'évaluation des dislocations, notamment des dislocations émergentes, existent. Les techniques de microscopie électronique en transmission (MET) ou de topographie aux rayons X permettent de détecter les défauts du réseau cristallin dans leur ensemble. Les dislocations émergentes et les dislocations enterrées, c'est-à-dire non propagées jusqu'à la surface, sont difficiles à distinguer. Or, les dislocations enterrées n'ont pas d'influence sur les propriétés électriques du film superficiel utile. L'interprétation des résultats obtenus est, par conséquent, difficile à réaliser.

D'autres techniques couramment utilisées consistent à révéler les défauts en surface par gravure chimique humide ou en phase vapeur. La surface de l'échantillon peut être au préalable oxydée puis soumise à une solution de gravure, généralement d'acide chlorhydrique ou fluorhydrique, qui grave sélectivement l'oxyde ainsi formé. La vitesse de gravure des zones présentant des dislocations est plus élevée que celle du monocristal parfait. Une ségrégation est alors réalisée, révélant préférentiellement les dislocations. Ces dernières sont révélées par ségrégation. Elles apparaissent alors sous forme de points en creux, directement observables, par exemple, au microscope optique ou électronique.

Dans l'article "A Wet Etching Technique to Reveal Threading Dislocations In Thin Germanium Layers", (Solid State Phenomena, vol. 134 (2008), 83-86), Souriau & al. décrit, par exemple, un procédé de révélation de dislocations par gravure humide de couches minces de germanium. La révélation des dislocations est obtenue par immersion de plaques de germanium dans des solutions de gravure à base de chrome et d'acide fluorhydrique.

Par ailleurs, le document WO2005/086222 décrit un procédé de révélation de dislocations émergentes par gravure en phase vapeur d'un film monocristallin à base de silicium et/ou de germanium à la surface d'un substrat. Plus particulièrement, le gaz gravant est de l'acide fluorhydrique ou chlorhydrique gazeux. Le procédé révélé outre le fait qu'il nécessite de manipuler des produits gazeux corrosifs et nocifs pour l'homme et l'environnement, est mis en oeuvre dans un bâti d'épitaxie, installation complexe et coûteuse.

### Objet de l'invention

L'invention a pour but de proposer un procédé de révélation de dislocations émergentes d'un élément ayant au moins une couche superficielle à base de germanium cristallin remédiant aux inconvénients de l'art antérieur.

En particulier, l'invention a pour but de proposer un procédé simple à mettre en oeuvre, peu coûteux et efficace aussi bien pour des substrats massifs de germanium que pour des couches minces de germanium et notamment des couches dont l'épaisseur est inférieure à 500nm.

Selon l'invention, ce but est atteint par un procédé de révélation selon les revendications indexées. En particulier, ce but est atteint par le fait qu'il comporte une étape de recuit de l'élément sous une atmosphère à base d'un mélange d'au moins un gaz oxydant et un gaz neutre.

Selon un mode de réalisation particulier, le gaz oxydant est de l'oxygène et le gaz neutre est de l'azote et/ou de l'argon. La proportion d'oxygène dans le mélange est comprise entre 0,5% et 95%.

### Description sommaire des dessins

D'autres avantages et caractéristiques ressortiront plus clairement de la description qui va suivre des modes particuliers de réalisation de l'invention donnés à titre d'exemples non limitatifs et représentés aux dessins annexés, dans lesquels :
- La figure 1 représente une micrographie optique d'un échantillon d'une première plaque GOS(1) après révélation selon le procédé de l'invention.
- La figure 2 représente une micrographie optique d'un échantillon d'une seconde plaque GOS (2) après révélation selon le procédé de l'invention
- La figure 3 représente une micrographie optique d'un échantillon d'une plaque de germanium massif Ge (1) après révélation selon le procédé de l'invention.
- La figure 4 représente une micrographie optique d'un échantillon d'une plaque GeOl (1) après révélation selon le procédé de l'invention.
- La figure 5 représente une micrographie optique d'un échantillon d'une troisième plaque GOS (3) après révélation selon le procédé de l'invention réalisée à une température de recuit de 700°C.

### Description des modes de réalisation particulière de l'invention

L'invention concerne un procédé de détection de défauts, plus particulièrement, de dislocations émergentes d'un élément ayant au moins une couche superficielle à base de germanium cristallin. Le germanium est un élément semi-conducteur couramment utilisé, sous sa forme cristalline, dans le domaine de la microélectronique notamment pour ses propriétés électriques et optiques. La couche superficielle à base de germanium cristallin est, avantageusement, une couche de germanium à structure monocristalline. Ce procédé est particulièrement avantageux pour des éléments formés d'un substrat sur lequel est déposée une couche à base de germanium. L'élément est, de préférence, constitué d'une couche superficielle de germanium formée sur un substrat. Le substrat peut être au moins partiellement isolant, de type "germanium-on-insulator" (GeOl), en silicium recouvert d'un film d'oxyde ou encore en silicium de type "germanium-on-silicium" (GOS).

Le substrat peut également être quelconque, massif ou formé de plusieurs couches, par exemple, d'une couche de silicium et d'un alliage silicium-germanium.

Le procédé peut s'appliquer à un élément massif ou ayant une couche superficielle à base de germanium cristallin d'une épaisseur quelconque et notamment inferieure à 500nm., de préférence comprise entre 10nm et 100nm, contrairement aux procédés de révélation chimique qui du fait de leur vitesse d'attaque élevée sont plutôt réservés aux couches d'épaisseur supérieure à 500nm.

Selon un procédé connu, des plaques GOS peuvent être obtenues par épitaxie c'est-à-dire croissance de cristaux d'une fine couche de germanium sur un substrat adapté par exemple, de silicium et/ou de SiGe. Les plaques de GeOl peuvent, quant à elles, être obtenues par condensation d'un film de SiGe ou par report de couches. Selon cette dernière technique, on peut par exemple assembler par collage moléculaire un substrat de germanium sur un substrat de silicium oxydé puis amincir le substrat de germanium. L'amincissement peut se faire par des moyens mécaniques ou par fracture au niveau d'une zone fragile enterrée présente dans le substrat de germanium et obtenue par exemple par implantation d'espèces gazeuses réalisées avant le collage, procédé connu sous le nom de procédé Smart Cut^{™}.

Selon un mode de réalisation particulier, le procédé de révélation de dislocations émergentes d'un élément ayant au moins une couche superficielle à base de germanium cristallin comporte une étape de recuit de l'élément sous atmosphère à base d'un mélange d'au moins un gaz oxydant et d'un gaz neutre. L'étape de recuit est mise en oeuvre dans un four. Le procédé peut être réalisé sans aucun prétraitement de l'élément. Il peut, avantageusement, consister en une seule étape de recuit. Il peut être réalisé sur des tranches complètes, par exemple de 200mm ou 300mm de diamètres, ou sur des fragments de tranches.

L'oxydation par recuit de l'élément est sélective du fait du champ de contrainte créé par la dislocation et/ou du phénomène de ségrégation d'impuretés de la dislocation. En effet, la présence d'une dislocation à la surface de la couche à base de germanium fait naître une imperfection à proximité de la dislocation qui favorise l'oxydation des atomes de germanium en oxyde de germanium. La vitesse d'oxydation au niveau des dislocations est donc plus rapide que celle du germanium dans le réseau cristallin parfait. L'oxyde de germanium ainsi crée sublime à une température de l'ordre de 500°C à 550°C. Le flux gazeux est, par exemple de l'oxygène pour le gaz oxydant et, de l'azote et/ou de l'argon pour le gaz neutre. Le flux gazeux entraîne l'oxyde de germanium formé à la surface de la couche superficielle de germanium et favorise la réaction d'oxydation. Une partie de l'épaisseur de la couche superficielle de germanium est alors consommée par ce traitement. Ce phénomène de gravure peut être caractérisé par une vitesse de gravure qui correspond à la valeur de l'épaisseur de la couche superficielle consommée par heure de traitement thermique. Le procédé de révélation est, néanmoins, peu destructeur de matière car la vitesse de gravure reste lente comparativement à la gravure chimique utilisée dans l'art antérieur pour la révélation de défauts dans le germanium. Des dépressions sont ainsi créées à la surface de la couche de germanium au niveau des dislocations émergeantes. Elles apparaissent sous forme de points visibles par des techniques conventionnelles d'observation. Les dislocations émergentes ainsi révélées sont, par exemple, directement observables par tout appareil de détection et de comptage automatique de défauts des lignes de production ou, de manière simple, par microscopie optique ou électronique. On calcule ainsi la densité de dislocation c'est-à-dire le nombre de dislocations émergentes par cm²

L'étape de recuit est, avantageusement, réalisée à une température de recuit supérieure ou égale à 500°C durant une période déterminée correspondant à la durée de recuit. La durée de recuit et la température seront déterminées en fonction de l'épaisseur de la couche superficielle et du taux de dislocation attendu. Plus l'épaisseur sera importante, plus la durée du recuit pourra être importante car plus on pourra enlever de matière sans nuire à la qualité de la couche superficielle résiduelle. Plus le taux de dislocation attendu sera élevé, plus la température de recuit devra être basse et sa durée courte afin d'éviter que les dépressions créées ne grossissent trop et fusionnent rendant impossible tout comptage significatif.

Selon un mode de réalisation préférentielle, la température de recuit est comprise entre 500°C et 700 °C, de préférence comprise entre 530 et 570°C, et de préférence égale à 550°C. Pour éviter de provoquer une détérioration de la couche superficielle ou une perte d'intégrité de l'élément, la température de recuit ne dépassera pas une température d'environ 700°C.

Un mélange d'oxygène O₂ et d'au moins un gaz inerte, par exemple un mélange d'oxygène O₂ et d'azote N₂, est maintenu, de préférence, dans le four pour soumettre l'élément à une atmosphère oxydante durant le traitement thermique. La proportion d'oxygène dans le mélange est comprise entre 0,5% et 95%.

Pour le gaz oxydant, d'autres espèces oxydantes peuvent être utilisées, par exemple, de la vapeur d'eau (H₂O) ou du protoxyde d'azote (N₂O).

À titre d'exemple, quatre plaques ayant une couche superficielle à base de germanium ont été traitées par le procédé décrit ci-dessus sans prétraitement préalable et pleine plaque pour une meilleure représentativité des résultats. L'observation des dislocations émergentes révélées a été effectuée à l'aide d'un microscope optique (de marque Zeiss) au grandissement x100 (taille du champ 41µm x 31µm). La première et la seconde plaques sont des substrats de silicium recouvert d'une couche épitaxiée de germanium, respectivement GOS(1) et GOS(2). La troisième plaque est une plaque de germanium massif Ge(1). La quatrième plaque est une plaque de GeOl(1) obtenue par report d'une couche mince de germanium issue de la plaque similaire à la plaque GOS(1) sur un substrat de silicium oxydé par le procédé Smart Cut^{™}.

Chacune des plaques a été traitée dans les mêmes conditions c'est-à-dire à une température de recuit égale à 550°C durant 1H sous un flux gazeux d'oxygène et d'azote avec un ratio respectivement de 0,7% et de 99,3%. Sous ces conditions, la vitesse de gravure est de l'ordre de 20nm/heure.

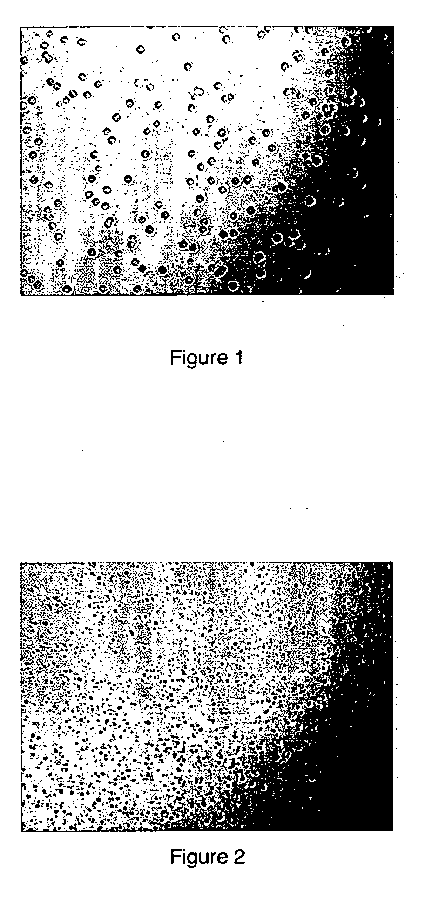

La figure 1 représente la micrographie obtenue à partir de la première plaque GOS(1). Elle révèle la présence de dislocations émergentes qui apparaissent sous forme de points 1. L'analyse par comptage évalue une densité de dislocation de 1,5.10⁷ dislocations/cm².

La figure 2 représente la micrographie obtenue à partir de la seconde plaque GOS(2). L'analyse par comptage permet de déterminer une densité de dislocation de 1,2.10⁸ dislocations/cm². On constate que cette densité de dislocation est plus importante que celle de la première plaque GOS(1).

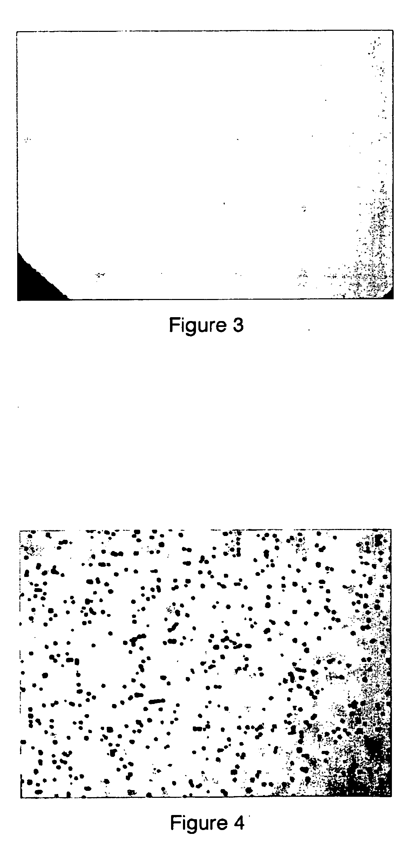

Comme représenté à la figure 3, la micrographie obtenue en microscopie optique de la plaque Ge(1), révèle une couche superficielle lisse sans dépressions (points). La plaque de germanium Ge(1) possède une structure monocristalline parfaite au niveau de sa couche superficielle.

La micrographie optique obtenue à partir de la quatrième plaque GeOl(1), est représentée à la figure 4. La couche de germanium du GeOl(1) a une épaisseur de 50 nm. La densité de dislocations émergentes a été déterminée par comptage des points observés. Elle est de 3,8.10⁷ dislocations/cm². Ces résultats sont du même ordre de grandeur que ceux observés sur la première plaque GOS(1), ce qui tend à prouver que le procédé de report de film utilisé n'a pas induit de manière significative de défauts supplémentaires dans la couche de germanium. Ceci confirme également que notre procédé de révélation peut s'appliquer à des couches très minces.

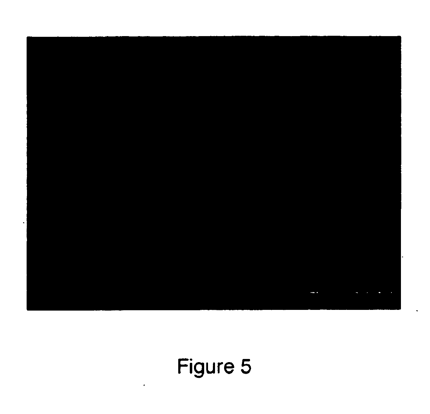

La figure 5 représente la micrographie optique à partir de la seconde plaque GOS(2) soumise au procédé de révélation décrit précédemment mais avec une étape supplémentaire à une température de 700°C. On constate une détérioration significative de l'intégrité de la surface de la plaque GOS(2) qui n'est plus utilisable.

Grâce aux résultats obtenus par ce procédé, on peut trier les éléments pour sélectionner ceux qui présentent les meilleures qualités cristallines c'est-à-dire le moins de dislocations émergeantes. Ce procédé peut être intégré à une ligne de production ou peut servir, par exemple, à sélectionner ponctuellement un élément parmi plusieurs provenant de différents fournisseurs.

Selon une variante, le procédé peut comporter d'autres étapes de traitement, par exemple, un prétraitement pour éliminer une éventuelle couche de passivation à la surface de l'élément.

Selon une autre variante, le recuit peut être optimisé en soumettant l'élément à un gradient de température avec un ou plusieurs paliers en température.

Le procédé décrit ci-dessus permet de révéler des dislocations émergentes d'une couche superficielle à base de germanium dans des conditions peu agressives et avec une vitesse de gravure compatible avec les couches minces à base de germanium c'est-à-dire d'épaisseur inférieure à 500nm, voire inférieure à 50 nm. Ce procédé est donc adapté aux plaques de GeOl et GOS.

De plus, contrairement aux procédés de l'art antérieur, le procédé de révélation décrit ci-dessus n'utilise pas de produits corrosifs ou nocifs pour l'homme et l'environnement. Par ailleurs, il ne nécessite pas de personnel dédié parce qu'il est simple à mettre en oeuvre, sans préparation préalable de l'élément. Ce procédé industrialisable, efficace, peut être utilisé pour une révélation aussi bien de morceaux que pleine plaque et donne des résultats représentatifs et reproductibles.

## Revendications

1. Procédé de révélation de dislocations émergentes d'un élément ayant au moins une couche superficielle à base de germanium cristallin, **caractérisé en ce qu'**il comporte une étape de recuit de l'élément sous une atmosphère à base d'un mélange d'au moins un gaz oxydant et un gaz neutre, et **en ce que** l'étape de recuit est réalisée à une température de recuit comprise entre 500°C et 700°C.

2. Procédé selon la revendication 1, **caractérisé en ce que** le gaz oxydant est de l'oxygène.

3. Procédé selon la revendication 2, **caractérisé en ce que** la proportion d'oxygène dans le mélange est comprise entre 0,5% et 95%.

4. Procédé selon la revendication 1, **caractérisé en ce que** le gaz oxydant est choisi parmi de la vapeur d'eau (H₂O) et du protoxyde d'azote (N₂O).

5. Procédé selon l'une quelconque des revendications 1 à 4, **caractérisé en ce que** le gaz neutre est de l'azote et/ou de l'argon.

6. Procédé selon l'une quelconque des revendications 1 à 5, **caractérisé en ce que** l'élément est constitué d'une couche superficielle de germanium formée sur un substrat.

7. procédé selon la revendication 6, **caractérisé en ce que** le substrat est au moins partiellement isolant.

8. Procédé selon la revendication 6, **caractérisé en ce que** le substrat est en silicium recouvert d'un film d'oxyde.

9. Procédé selon la revendication 6, **caractérisé en ce que** le substrat est en silicium.

10. Procédé selon l'une quelconque des revendications 1 à 9, **caractérisé en ce que** la couche superficielle à base de germanium cristallin a une épaisseur inférieure à 500nm.

11. Procédé selon la revendication 10, **caractérisé en ce que** l'épaisseur est comprise entre 10nm et 100nm.

12. Procédé selon la revendication 1 **caractérisé en ce que** la température de recuit est comprise entre 530° C et 570°C.

## Claims

1. A method for revealing emergent dislocations of an element having at least one crystalline germanium-base superficial layer, **characterized in that** it comprises an annealing step of the element in an atmosphere having a base that is a mixture of at least an oxidizing gas and a neutral gas and **in that** the annealing step is performed at an annealing temperature comprised between 500°C and 700°C.

2. The method according to claim 1, **characterized in that** the oxidizing gas is oxygen.

3. The method according to claim 2, **characterized in that** the proportion of oxygen in the mixture is comprised between 0.5% and 95%.

4. The method according to claim 1, **characterized in that** the oxidizing gas is chosen from water vapor (H₂O) and nitrous oxide (N₂O).

5. The method according to any one of claims 1 to 4, **characterized in that** the neutral gas is nitrogen and/or argon.

6. The method according to any one of claims 1 to 5, **characterized in that** the element consists of a germanium superficial layer formed on a substrate.

7. The method according to claim 6, **characterized in that** the substrate is at least partially insulating.

8. The method according to claim 6, **characterized in that** the substrate is made from silicon coated with an oxide film.

9. The method according to claim 6, **characterized in that** the substrate is made from silicon.

10. The method according to any one of claims 1 to 9, **characterized in that** the crystalline germanium-base superficial layer has a thickness of less than 500nm.

11. The method according to claim 10, **characterized in that** the thickness is comprised between 10nm and 100nm.

12. The method according to claim 11, **characterized in that** the annealing temperature is comprised between 530°C and 570°C.

## Patentansprüche

1. Verfahren zur Aufdeckung auftretender Verschiebungen eines Elements, das mindestens eine Oberflächenschicht auf Basis von kristallinem Silizium hat, **dadurch gekennzeichnet, dass** es einen Schritt des Glühens des Elements unter einer Atmosphäre auf Basis eines Gemischs aus mindestens einem oxidierenden Gas und einem Schutzgas umfasst und dass der Glühschritt auf einer Glühtemperatur von 500°C bis 700°C vorgenommen wird.

2. Verfahren nach Anspruch 1, **dadurch gekennzeichnet, dass** das oxidierende Gas Sauerstoff ist.

3. Verfahren nach Anspruch 2, **dadurch gekennzeichnet, dass** der Anteil des Sauerstoffs in dem Gemisch 0,5% bis 95% beträgt.

4. Verfahren nach Anspruch 1, **dadurch gekennzeichnet, dass** das oxidierende Gas ausgewählt ist aus Wasserdampf (H₂O) und Lachgas (N₂O).

5. Verfahren nach einem der Ansprüche 1 bis 4, **dadurch gekennzeichnet, dass** das Schutzgas Stickstoff und/oder Argon ist.

6. Verfahren nach einem der Ansprüche 1 bis 5, **dadurch gekennzeichnet, dass** das Element aus einer Oberflächenschicht aus Germanium besteht, die auf einem Substrat gebildet ist.

7. Verfahren nach Anspruch 6, **dadurch gekennzeichnet, dass** das Substrat zumindest teilweise nichtleitend ist.

8. Verfahren nach Anspruch 6, **dadurch gekennzeichnet, dass** das Substrat aus mit einer Oxidschicht überzogenem Silizium besteht.

9. Verfahren nach Anspruch 6, **dadurch gekennzeichnet, dass** das Substrat aus Silizium besteht.

10. Verfahren nach einem der Ansprüche 1 bis 9, **dadurch gekennzeichnet, dass** die Oberflächenschicht auf Basis von kristallinem Germanium eine Dicke von unter 500 nm hat.

11. Verfahren nach Anspruch 10, **dadurch gekennzeichnet, dass** die Dicke 10nm bis 100nm beträgt.

12. Verfahren nach Anspruch 1, **dadurch gekennzeichnet, dass** die Glühtemperatur 530°C bis 570°C beträgt.
